# FASCICULE DE BREVET EUROPEEN

(11) **EP 2 729 822 B1**
(45) Date de publication et mention de la délivrance du brevet: **01.05.2019**
(21) Numéro de dépôt: 12732652.8
(22) Date de dépôt: 04.07.2012
(51) Int. Cl.: G01R 31/12

(54) **DETECTION D'ARCS ELECTRIQUES DANS LES INSTALLATIONS PHOTOVOLTAÏQUES**
NACHWEIS VON ELEKTRISCHEN LICHTBÖGEN BEI EINER FOTOVOLTAIKANLAGE
DETECTION OF ELECTRICAL ARCS IN PHOTOVOLTAIC EQUIPMENT

(30) Priorité: 04.07.2011 FR 1156012
(43) Date de publication de la demande: 14.05.2014
(73) Titulaire: Commissariat à l'Énergie Atomique et aux Énergies Alternatives, 75015 Paris (FR)
(72) Inventeur: CHAINTREUIL, Nicolas, F-73800 Montmelian (FR); CHAUVE, Vincent, F-42560 Saint Jean Soleymieux (FR)
(74) Mandataire: Ahner, Philippe
(86) Numéro de dépôt international: PCT/EP2012/063063
(87) Numéro de publication internationale: WO 2013/004762

(56) Documents cités:
- EP-A2- 1 796 238
- WO-A1-2011/017721
- US-A1- 2011 019 444

## Description

### DOMAINE TECHNIQUE ET ART ANTERIEUR

L'invention concerne les installations photovoltaïques et, en particulier, les moyens de détection d'arcs électriques dans ces installations.

Les installations utilisant des panneaux photovoltaïques (PV) sont appelées à se développer. Or ce type de dispositif vieillit et des défaillances peuvent apparaître au cours du temps. Celles-ci peuvent être bénignes (par exemple : arrêt de fonctionnement, perte de production, baisse du rendement...) mais peuvent aussi être plus graves si un arc électrique en série apparaît sur une connexion. En effet, la conséquence d'un tel phénomène peut être, dans le pire des cas, un départ d'incendie pouvant aller jusqu'à la destruction du bâtiment dans lequel un module PV est installé.

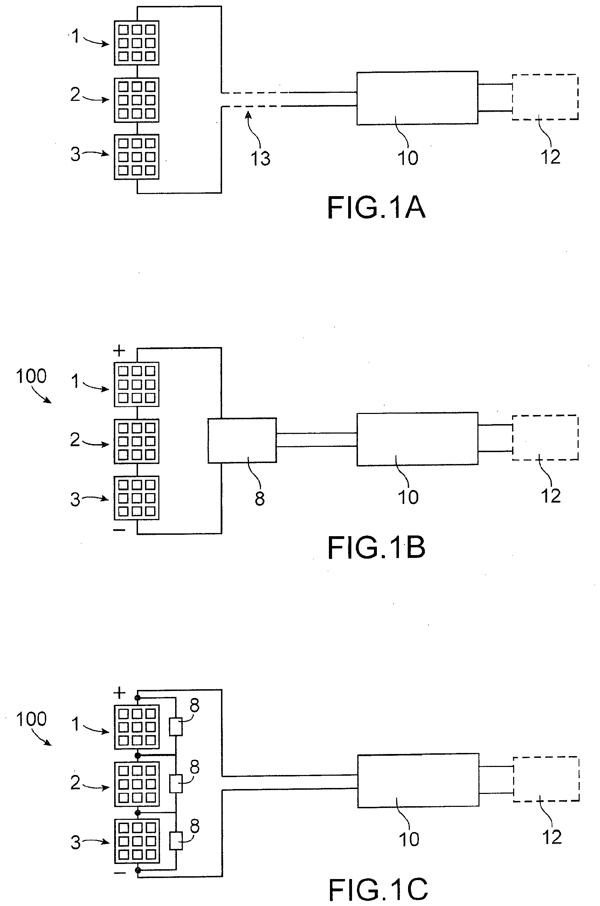

La figure 1A représente la localisation d'un arc dans un système de type connu, comportant 3 modules photovoltaïques 1, 2, 3 et un convertisseur (ou onduleur) 10, relié au réseau électrique 12. C'est dans une zone 13, entre les modules photovoltaïques 1, 2, 3 et l'onduleur 10, qu'un arc série peut se produire. Des arcs électriques peuvent aussi se produirent au sein des modules ou entre les modules.

On cherche donc à développer des systèmes permettant de détecter les arcs électriques dès leur apparition, afin de les interrompre et de limiter très fortement leur influence sur l'installation et son environnement.

Des solutions connues de détection d'arcs électriques dans les installations basse tension en courant continu ou alternatif sont principalement basées sur une détection ultrasonore (par signature acoustique de l'arc) ou radiofréquence (par signature RF de l'arc) ou encore sur des mesures thermiques (signature infrarouge de l'arc). La signature d'un phénomène est l'ensemble des caractéristiques et deleurs valeurs qui permet de l'identifier de façon certaine.

Pour les installations PV, le même type de détecteur commence à être développé par certains laboratoires ou industriels. La principale contrainte de ces systèmes repose sur leur moyen de mesure de la signature. En effet, les signatures étant complexes et généralement à des fréquences élevées (pour les signatures acoustiques et RF) elles nécessitent un traitement logiciel très lourd, avec un échantillonnage élevé, et donc des composants coûteux. De plus, le temps de traitement, incluant une discrimination du bruit ou des perturbations par rapport à la signature de l'arc, peut être élevé, allant de quelques secondes à quelques minutes.

Ces solutions ne répondent donc pas à un besoin de mise en sécurité rapide, fiable et à bas coût.

Le document FR 2912848 décrit comment utiliser la mesure d'une variation rapide de la tension pour détecter un arc électrique série. C'est cette variation que l'on cherche à évaluer finement.

Le document WO 2011/17721 décrit une méthode pour détecter les arcs électriques dans un système PV. Cette détection est basée sur une mesure moyenne du courant et dont l'évolution est observée.

Cette solution nécessite une mesure longue et un traitement long.

D'autres documents pertinents sont les documents US 2011/019444 A1 et EP 1 796 238 A2.

### EXPOSÉ DE L'INVENTION

Un procédé selon l'invention est défini dans la revendication indépendante 1 et un dispositif selon l'invention est défini dans la revendication indépendante 7.

On décrit ici une mesure de tension et la détection de la signature caractéristique de l'arc électrique d'un système photovoltaique, en courant continu, pour effectuer une détection rapide et fiable.

Plus particulièrement, on décrit un procédé de détection d'un arc série dans un dispositif photovoltaïque, fonctionnant en courant continu, comportant N (N=1 ou N>1) modules photovoltaïques, reliés à un dispositif de charge présentant un comportement capacitif pour les modules, ce procédé comportant :
a) détecter, aux bornes de n des N modules (1< n < N), l'évolution temporelle de la tension,
b) identifier une variation de tension entre une première zone (A) de tension stable et une deuxième zone (B) de tension stable pendant une durée d'au moins 5µs, qui suit immédiatement ladite variation de tension, et
c) déterminer si la variation de tension est comprise entre une valeur Vmin supérieure ou égale à 0,2 V et une valeur Vmax inférieure ou égale à 20 V, avec un temps de montée de cette variation compris entre une durée Tmin supérieure ou égale à 0,5 µs et une durée Tmax inférieure ou égale à 5 µs.

L'étape c) peut être réalisée, en tout ou partie, par analyse ou calcul de la pente de la variation de tension, et en déterminant si elle est comprise entre Vmin/Tmax (0,04V/µs) et Vmax/Tmin (40 V/µs).

L'étape de détection a) peut être réalisée aux bornes de l'ensemble des N modules photovoltaïques. On peut alors considérer que la valeur Vmin est supérieure ou égale à 10V et la valeur Vmax inférieure ou égale à 20V.

Les matériaux constitutifs des connexions des modules photovoltaïques définissent une valeur de tension d'arc VARC. Dans ce procéde, les valeurs Vmin et Vmax peuvent être positionnées de part et d'autre de cette valeur de tension d'arc VARC prédéfinie pour les matériaux considérés.

Les durées Tmin et Tmax peuvent être positionnées de part et d'autre d'une durée Tarc correspondant à la durée permettant d'appliquer une variation de tension aux bornes de l'ensemble des modules photovoltaïques égale à VARC.

L'étape de détection a) peut être réalisée aux bornes d'un sous-ensemble de n des N modules photovoltaïques.

Dans ce cas, les valeurs Vmin et Vmax peuvent être positionnées de part et d'autre d'une valeur VArc*n/N, VArc correspondant à la tension d'arc prédéfinie pour les matériaux constitutifs des connexions des modules photovoltaïques considérés, la valeur Vmax étant inférieure ou égale à 20V*n/N.

Les durées Tmin et Tmax sont de préférence positionnées de part et d'autre d'une durée Tarc*n/N, avec Tarc correspondant à la durée permettant d'appliquer une variation de tension aux bornes de l'ensemble des modules photovoltaïques égale à VARC, Tarc*n/N étant inférieure ou égale à 5*n/N µs.

Les tensions mesurées peuvent être numérisées, les étapes a) à c) étant réalisées à partir de valeurs numériques de la tension.

On décrit également un dispositif de détection d'un arc série dans un dispositif photovoltaïque, fonctionnant en courant continu, comportant N (N=1 ou N>1) modules photovoltaïques et un dispositif ou des moyens présentant un comportement capacitif pour les modules, ce dispositif de détection comportant :
a) des moyens pour détecter, aux bornes de n des N modules, l'évolution temporelle de la tension,
b) des moyens pour identifier une variation de tension entre une première zone (A) de tension stable et une deuxième zone (B) de tension stable pendant une durée d'au moins 5µs, qui suit immédiatement ladite variation de tension,
c) des moyens pour déterminer si la variation de tension est comprise entre une valeur Vmin supérieure ou égale à 0,2 V et une valeur Vmax inférieure ou égale à 20 V, avec un temps de montée de cette variation compris entre une durée Tmin supérieure ou égale à 0,5 µs et une durée Tmax inférieure ou égale à 5 µs.

Les moyens déterminant si la variation de tension est comprise entre Vmin et Vmax, et si le temps de montée est compris entre Tmin et Tmax peuvent réaliser une analyse ou un calcul ou une mesure de la pente de la variation de tension et déterminer si cette pente est comprise entre Vmin/Tmax (0,04V/µs) et Vmax/Tmin (40 V/µs).

L'évolution temporelle de la tension peut être détectée aux bornes de l'ensemble des N modules photovoltaïques, la valeur Vmin étant supérieure ou égale à 10V et la valeur Vmax étant inférieure ou égale à 20V.

De préférence, les valeurs Vmin et Vmax sont positionnées de part et d'autre d'une valeur de tension d'arc VARC prédéfinie pour les matériaux constitutifs des connexions des modules Photovoltaïques considérés.

Les durées Tmin et Tmax peuvent être positionnées de part et d'autre d'une durée Tarc correspondant à la durée nécessaire pour appliquer une variation de tension aux bornes de l'ensemble des modules photovoltaïques égale à VARC.

L'évolution temporelle de la tension peut être détectée aux bornes d'un sous-ensemble de n des N modules photovoltaïques.

Les valeurs Vmin et Vmax peuvent alors être positionnées de part et d'autre d'une valeur VArc*n/N, VArc correspondant à une tension d'arc prédéfinie pour les matériaux constitutifs des connexions des modules photovoltaïques considérés, la valeur Vmax étant inférieure ou égale à 20V*n/N. Les durées Tmin et Tmax peuvent être positionnées de part et d'autre d'une durée Tarc*n/N, avec Tarc correspondant à la durée nécessaire pour appliquer une variation de tension aux bornes de l'ensemble des modules photovoltaïques égale à VARC, Tarc*n/N étant inférieure ou égale à 5*n/N µs.

Un tel dispositif peut comporter des moyens pour filtrer des fréquences au moins égales à 100Hz.

Il peut comporter des moyens de filtrage formant filtre passif ou formant filtre actif et/ou des moyens de filtrage analogiques et/ou numériques.

Des moyens peuvent être prévus pour numériser les tensions mesurées.

Le dispositif ou les moyens présentant un comportement capacitif pour les modules peut/peuvent comporter un convertisseur ou un onduleur ou une batterie.

### BREVE DESCRIPTION DES FIGURES

- La figure 1A représente la localisation d'un arc dans un système de type connu,
- les figures 1B et 1C représentent schématiquement une structure générale d'une installation photovoltaïque, avec des moyens de détection d'arc, positionnés entre module photovoltaique et convertisseur (figure 1B), ou entre modules (figures 1C),
- la figure 2 représente les variations d'une tension, au cours du temps, lors d'un arc électrique au bord d'un dispositif photovoltaïque,
- la figure 3 représente un mode de réalisation d'un dispositif selon l'invention,
- la figure 4 représente un autre mode de réalisation d'un dispositif selon l'invention,
- la figure 5 représente encore un autre mode de réalisation d'un dispositif selon l'invention,
- la figure 6 représente des courbes courant/tension caractéristiques d'un module photovoltaïque,
- la figure 7 représente un mode de réalisation numérique d'un dispositif selon l'invention.

### EXPOSÉ DÉTAILLÉ DE MODES DE RÉALISATION PARTICULIERS

La figure 1B représente représente schématiquement la structure d'une installation photovoltaïque, comportant 3 modules photovoltaïques 1, 2, 3, des moyens 8 de mesure d'arc, et un élément 10 imposant une charge capacitive à la sortie de l'installation, ou encore présentant un comportement capactitif pour les modules, tel qu'un convertisseur ou un onduleur ou une batterie.

Cet élément 10 est relié au réseau électrique 12. C'est entre les modules photovoltaïques 1, 2, 3 et/ou cet élément 10 qu'un arc peut se produire. Ou bien, l'arc peut se produire entre les modules PV ou dans les modules PV, c'est-à-dire entre les cellules d'un module PV.

On appelle module photovoltaïque un assemblage monolithique de cellules photovoltaïques.

La présente description n'est pas limitée à trois modules photovoltaïques, mais s'applique à un nombre N quelconque de ces modules. Dans la suite du texte, on désignera l'ensemble des modules voltaïques par la seule référence numérique 100.

Les moyens 8 de mesure d'arc sont placés entre les modules photovoltaïques 100 et les moyens 10. Ils permettent de mesurer la tension du groupe de modules photovoltaïques. Si on veut détecter les arcs électriques dans les modules ou entre les modules d'une série de modules, des moyens 8 de mesure sont placés aux bornes de chaque module 1, 2, 3 de cette série de modules, comme illustré en figure 1C. On peut aussi avoir une mesure aux bornes d'une série de n modules (1≤n<N).

Grâce à leur capacité d'entrée, ou à leur charge d'entrée de nature capacitive, les moyens 10 permettent, pendant la durée d'établissement d'un arc, de maintenir une tension stable en sortie de la chaîne de modules PV 100. Comme déjà indiqué ci-dessus, en variante, on peut prévoir un onduleur, ou une charge capacitive telle qu'un convertisseur ou une batterie, qui permettra le même effet de stabilisation.

La tension et le courant débités par les modules photovoltaïques dépendent de plusieurs paramètres (ensoleillement, température), et peuvent varier d'une façon importante.

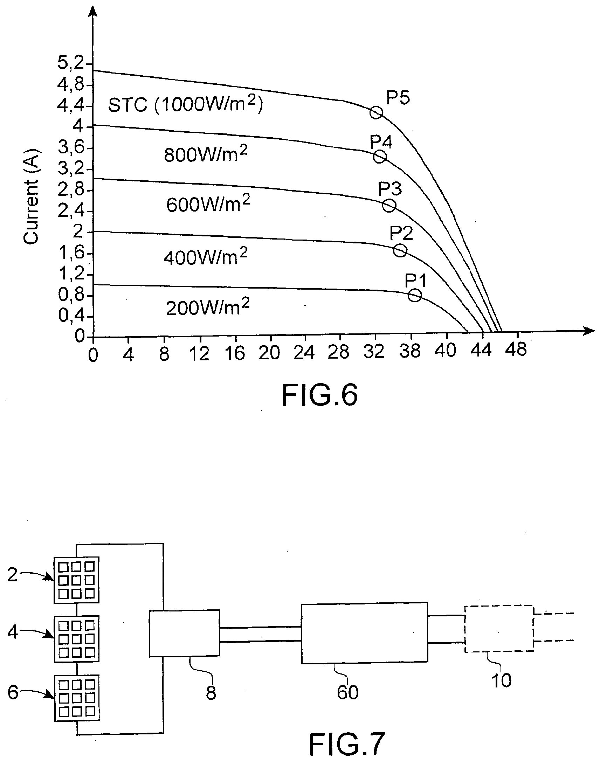

La figure 6 montre des courbes caractéristiques d'un module photovoltaïque en fonction de l'éclairement reçu (de 200 à 1000W/cm2). Le courant débité par le module varie fortement en fonction de cet éclairement (proportionnellement dans une première approximation). Les points de fonctionnement P1, P2,...Pk sur les courbes de la figure 6 sont les points où le module délivre le maximum de puissance pour un éclairement donné.

Afin d'optimiser la production d'énergie, le convertisseur ou l'onduleur 10 impose une tension de fonctionnement des modules de façon à ce que ces derniers produisent le maximum de puissance (cette fonction est appelée : MPPT = « maximum power point tracking »).

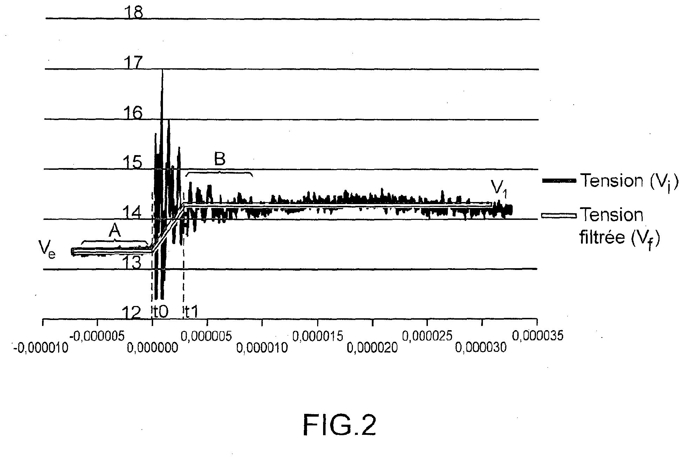

Les moyens 8 permettent d'identifier, sur la mesure de la tension, une signature caractéristique d'un arc électrique, qui se traduit par une hausse rapide de la tension aux bornes du dispositif PV 100. Cette variation se traduit par une évolution de la tension instantanée Vᵢ, qui présente de fortes oscillations et qui peut prendre la forme représentée en figure 2. Est également représentée la tension V_{f}, qui résulte d'un filtrage de la tension instantanée Vᵢ. On note que les variations de tension se produisent entre une 1^{ère} zone de stabilité en tension (zone A sur la figure 2), à une valeur de tension V₀ dite valeur initiale, et une 2^{ème} zone de stabilité en tension (zone B sur la figure 2), à une valeur V₁ de tension dite valeur finale. Cette 2^{ème} zone de stabilité a une durée d'au moins quelques µs, par exemple au moins 5 µs ou au moins 10 µs. Par conséquent, la variation qui résulte du front de tension fait varier la valeur de la tension.

A la suite du front de montée, la tension s'établi à la valeur finale V₁ du front de tension égale à environ V₀ + VARC, et reste sensiblement à cette valeur pendant la durée minimale indiquée ci-dessus.

Les oscillations de tension observées au début du front de la tension instantanée Vᵢ peuvent varier. La signature se caractérise, entre la 1^{ère} zone de stabilité en tension et la 2^{ème} zone de stabilité en tension, par une évolution positive ΔV (= V1 - V0) de la tension Vᵢ (mais, également, de Vg, puisque celle-ci est directement déduite de Vᵢ, par lissage de la courbe Vᵢ) d'une valeur comprise entre 0,2V et 20V.

Cette valeur est variable suivant le lieu de la mesure et le nombre de modules PV qui se trouvent dans la chaîne de modules PV 100 où le détecteur d'arcs est implanté, comme expliqué ci-dessous.

La valeur maximale de ΔV de 20V est liée aux caractéristiques physiques d'un arc électrique. En effet, comme d'ailleurs déjà expliqué dans le document FR 2 912 848, un arc électrique peut être décomposé en 3 zones :
- 1 zone d'interface électrode/air
- 1 zone de plasma
- 1 zone d'interface air/électrode.

Les deux zones d'interface se présentent comme une jonction PN d'une diode, à savoir une jonction entre un matériau conducteur et un isolant.

Cette jonction présente donc un potentiel fixe qui est directement lié aux potentiels des matériaux en présence. Celui de l'air ne varie pas, en revanche celui de l'électrode peut varier suivant que l'électrode est en cuivre, ou en aluminium, ou en argent... Ce potentiel est donc présent à chaque interface et est caractéristique de l'arc. Il apparaît dès l'amorçage (avant établissement du plasma) et sa valeur maximale, mesurée aux bornes de l'arc, est comprise entre 10V et 20V.

Cette valeur mesurée est différente suivant l'emplacement du détecteur d'arc 8. Elle a une valeur maximum de 10V à 20V en tête de l'installation photovoltaïque (avec une mesure entre la borne positive + du module 1 et la borne négative du module n).

Si le détecteur d'arcs se trouve aux bornes de n'importe lequel des modules 1, 2, 3, ...... ou N, la valeur de la tension vue par le détecteur d'arc est divisée par un facteur égal à N (+/- 5 %) où N est le nombre de modules PV dans la chaîne PV.

En reprenant les notations déjà utilisées ci-dessus, la tension mesurée au niveau d'un seul module de la chaine aura varié, en fin d'établissement d'un arc, de VARC/N (+/-5%) où N est le nombre de modules PV dans la chaine. En effet, si la variation de tension aux bornes de l'ensemble est de VARC, cette variation se répartira sur chacun des N modules. Si la tension est mesurée aux bornes d'un ensemble de n modules parmi les N modules de la chaine, elle aura une variation de nxVARC/(N).

Un autre paramètre d'un arc électrique série apparaissant dans un système photovoltaïque est le temps de montée ΔT du front de tension de l'arc électrique (de t₀ à t₁ sur la courbe II de la figure 2), qui est mesuré entre la valeur initiale V₀ de la tension et la valeur finale V₁ (de Vf), avec une marge d'erreur, par exemple plus ou moins 10%, cette marge d'erreur étant due au bruit sur la forme d'onde. Ce temps de montée est lié aux caractéristiques physiques des modules photovoltaïques et à leur comportement dynamique. Un module PV représente une certaine valeur de capacité parasite ou équivalente variable. Il possède donc un temps de réponse à un échelon de tension qui lui est caractéristique. Mais ce temps varie peu selon les différentes technologies de modules PV ; il est compris entre 0,5 µs et 5 µs.

Comme pour la variation de tension, cette valeur de temps de montée est divisée par le nombre de modules lorsque la tension est mesurée aux bornes d'un seul module de la chaîne. Aux bornes d'un ensembe de n modules parmi un ensemble de N modules, il sera de nx ΔT/N.

Ces spécificités permettent d'identifier, entre 2 zones de stabilité de la tension, la signature d'un arc électrique série, caractéristique du milieu d'un système PV, à l'aide de la variation ΔV de tension identifiée et de la valeur ΔT du temps de montée.

De manière similaire ou équivalente, on peut identifier un arc :
- par la durée ΔT et la pente de la variation de tension lors de son évolution temporelle ;
- par la variation de tension ΔV et la pente de la variation de tension lors de son évolution temporelle.

La présence d'un arc se traduit :
- par une variation de tension maximale comprise entre 10 V et 20 V (si la mesure est faite aux bornes de l'ensemble des modules), avec un temps de montée compris entre 0,5 µs et 5 µs ;
- ou par une pente du front de tension comprise entre 40 V/µs ou 0,04V/µs, avec un temps de montée compris entre 0,5 µs et 5 µs ;
- ou par une pente du front de tension comprise entre 40 V/µs ou 0,04V/µs, avec par une variation de tension maximale comprise entre 10 V et 20 V (si la mesure est faite aux bornes de l'ensemble des modules).

En d'autres termes, on détermine, d'une manière ou d'une autre, si la variation de tension est comprise entre une valeur Vmin supérieure ou égale à 0,2 V et une valeur Vmax inférieure ou égale à 20 V, avec un temps de montée de cette variation compris entre une durée Tmin supérieure ou égale à 0,5 µs et une durée Tmax inférieure ou égale à 5 µs.

Si la mesure ou la détection est réalisée aux bornes de l'ensemble des N modules photovoltaïques, la valeur Vmin est supérieure ou égale à 10V et la valeur Vmax inférieure ou égale à 20V.

Les valeurs ci-dessus sont adaptées lorsque la mesure est réalisée aux bornes d'un seul module ou d'un ensemble de n modules parmi les N modules ; mais la valeur de la pente de la variation ou du front de tension reste la même dans les deux cas.

Ainsi, si l'étape de détection est réalisée aux bornes d'un sous-ensemble de n des N modules photovoltaïques, on peut considérer une valeur Vmax inférieure ou égale à 20V*n/N, Tarc*n/N étant inférieure ou égale à 5*n/N µs.

Des exemples de réalisation d'un dispositif pour détecter un arc mettent en oeuvre des moyens techniques permettant de faire l'acquisition du signal et de discriminer une signature du type décrite ci-dessus.

Pour cela différentes solutions techniques sont possibles.

Avec chacune des solutions proposées ci-dessous, on cherche à isoler la signature de l'arc électrique des autres perturbations de la tension observées à l'entrée des moyens 8 formant détecteur d'arcs. En effet, sur un système PV la tension n'est pas parfaitement lisse, il demeure des perturbations, en particulier à 100Hz, de forme sinusoïdale et d'amplitude variable suivant le niveau de puissance injecté par l'onduleur 10 sur le réseau : ce sont des harmoniques générées par l'onduleur, qui se reportent à son entrée et donc sur la partie continue de l'installation PV. Certaines perturbations peuvent être à plus haute fréquence, par exemple des perturbations de type Dirac, qui représentent des perturbations de démarrage moteur ou de tout autre élément proche de l'installation PV et émettant des perturbations électromagnétiques. Par exemple, un moteur peut se trouver dans un environnement proche de l'installation PV et émettre un champs électromagnétique perturbateur ou être alimenté par la sortie de l'onduleur.

Enfin, des perturbations liées à l'utilisation d'une communication par courant porteur en ligne (CPL) peuvent gêner le détecteur d'arcs. Ces dernières peuvent provenir, par exemple, de la présence, dans l'installation PV, de systèmes intelligents et communiquant par courant porteur en ligne (CPL).

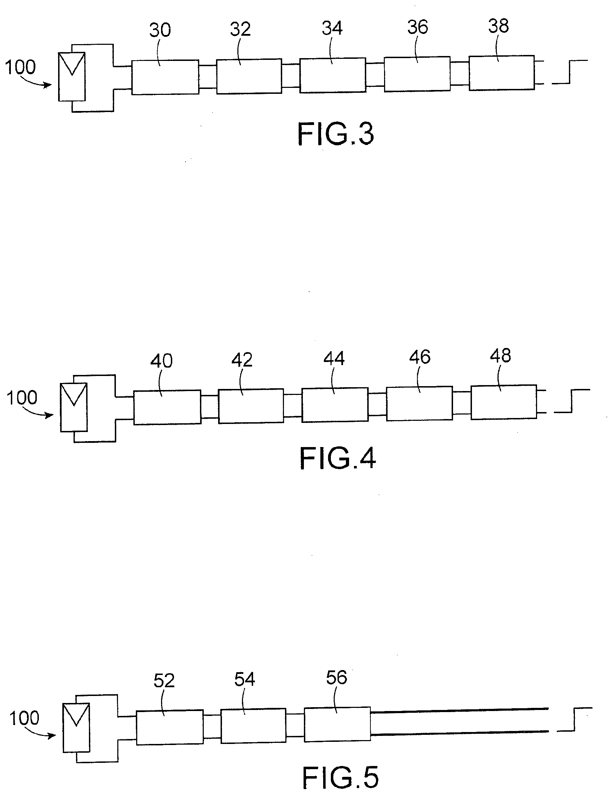

Un premier exemple de réalisation consiste en l'utilisation de filtres passifs analogiques en cascade, comme illustré en figure 3. Il comporte 3 étages : un 1^{er} filtre passif 30 (passe bande), un 2^{ème} filtre passif 32 (passe haut) et un amplificateur 34.

Ces étages peuvent être regroupés en 1 seul. En figure 3, ces étages peuvent être suivis d'un buffer 36 et de moyens 38 de découplage, pour découpler le module PV du circuit électrique afin de le mettre en sécurité. Le buffer permet de filtrer les rebonds du signal mesuré. Un arc électrique est rarement franc et est constitué d'une multitudes d'amorçages avant de stabiliser son plasma : il convient de détecter seulement le premier amorçage.

Les filtres 30, 32 permettent d'isoler la bonne fréquence (avec le temps caractéristique de montée du front entre 0,5 µs et 2µs) et donc de rejeter les basses fréquences (en dessous de 1000 Hz) et les hautes fréquences.

Comme illustré en figure 4, ce filtrage peut aussi être effectué avec des éléments actifs permettant d'en augmenter la sélectivité (ordre 6 au lieu de l'ordre 1 ou 2 avec le filtrage passif). Ce dispositif illustré en figure 4 comporte :
- des moyens 40 formant filtre actif (passe haut),
- des moyens 42 formant amplificateur et comparateur, des moyens 44 formant filtre passif (passe bas),
- des moyens 44 formant filtre passif (passe bas),
- un buffer 46,
- et de moyens 48 de découplage.

Enfin, une combinaison de moyens analogiques et de moyens numériques est possible, comme illustré en figure 5, comportant :
- des moyens 52 de découplage,
- des moyens 54 formant amplificateur et comparateur,
- des moyens 56 de traitement numérique.

D'autres modes de réalisation sont possibles, par exemple les fonctions d'amplification et de comparaison ne sont pas nécessairement dans un même dispositif 54.

Globalement, plus on privilégie un système analogique, plus le temps de réponse du dispositif est rapide. Il est intéressant d'avoir un temps de réponse rapide (de quelques dizaines de microsecondes) car il est ainsi possible de limiter l'apparition du plasma d'arc, évitant ainsi des dégradations physiques sur le système. Plus le nombre de composants pour réaliser la fonction est réduit, plus le coût sera réduit, d'où l'intérêt de ne travailler que sur la signature en tension et en analogique (pas en courant ou en RF et avec un traitement numérique lourd derrière).

Dans les divers dispositifs décrits, on détecte la tension et le temps de montée correspondant, conformément à l'un des procédés décrits ci-dessus, et en particulier :
- grace au comparateur, une variation de tension maximale comprise entre 0,2 V et 20 V,
- grâce à la sélectivité des filtres, un temps de montée de cette variation compris entre 0,5 µs et 5 µs.

Un autre mode de réalisation est illustré en figure 7 : il s'agit d'un mode numérique, utilisant une chaîne d'acquisition et un convertisseur analogique/numérique 60 qui permet de différencier la signature des autres bruits ambiants. Ce mode de réalisation numérique ne nécessite pas de filtrage. De préférence, le convertisseur 60 permet d'échantillonner le signal à une fréquence égale à 4 MHz ou à 5 MHz. Des moyens de traitement numérique permettent de calculer les différete svaleurs et de mettre en oeuvre les étapes de traitement selon l'invention.

Dans un procédé selon l'invention :
- on peut réaliser un filtrage passif ou actif à l'aide de moyens analogiques et numériques ;
- le dispositif de charge peut comporter un convertisseur ou un onduleur ou une batterie.

## Revendications

1. Procédé de détection d'un arc série dans un dispositif photovoltaïque, fonctionnant en courant continu, comportant N modules photovoltaïques (100, 1, 2, 3), N étant égal à 1 ou strictment supérieur à 1, ces modules étant reliés à un dispositif de charge (10) présentant un comportement capacitif pour les modules, ce procédé comportant :
a) détecter, aux bornes de n des N modules, n étant supérieur ou égal à 1 ou inférieur ou égal à N, l'évolution temporelle de la tension,
**caractérisé en ce que** ce procédé comporte en outre :
b) identifier une variation de tension entre :
- une première zone (A) de tension stable ;
- et une deuxième zone (B) de tension, stable pendant une durée d'au moins 5µs, qui suit immédiatement ladite variation de tension, et
c) déterminer si la variation de tension est comprise entre une valeur minimum Vmin supérieure ou égale à 0,2 V et une valeur maximum Vmax inférieure ou égale à 20 V, avec un temps de montée de cette variation compris entre une durée minimum Tmin supérieure ou égale à 0,5 µs et une durée maximum Tmax inférieure ou égale à 5 µs.

2. Procédé selon la revendication 1, dans lequel l'étape de détermination c) est réalisée :
- d'une part par analyse de la pente de la variation de tension en déterminant si cette pente est comprise entre :
* une valeur minimum, donnée par le rapport Vmin/Tmax, égale à 0,04V/µs
* et une valeur maximum, donnée par le rapport Vmax/Tmin égale à 40 V/µs,
- et, d'autre part, en déterminant si la variation de tension est comprise entre une valeur minimum Vmin supérieure ou égale à 0,2 V et une valeur maximum Vmax inférieure ou égale à 20 V, ou si le temps de montée de cette variation compris entre une durée minimum Tmin supérieure ou égale à 0,5 µs et une durée maximum Tmax inférieure ou égale à 5 µs.

3. Procédé selon la revendication 1 ou 2, dans lequel l'étape de détection a) est réalisée aux bornes de l'ensemble des N modules photovoltaïques, la valeur Vmin étant supérieure ou égale à 10V et la valeur Vmax étant inférieure ou égale à 20V

4. Procédé selon la revendication 1 ou 2 ou 3 dans lequel :
- les valeurs Vmin et Vmax sont positionnées de part et d'autre d'une valeur de tension d'arc VARC prédéfinie pour les matériaux constitutifs des connexions des modules photovoltaïques considérés,
- et les durées Tmin et Tmax sont positionnées de part et d'autre d'une durée Tarc correspondant à la durée nécessaire pour appliquer une variation de tension aux bornes de l'ensemble des modules photovoltaïques égale à VARC.

5. Procédé selon la revendication 1 ou 2, dans lequel l'étape de détection a) est réalisée aux bornes d'un sous-ensemble de n des N modules photovoltaïques.

6. Procédé selon la revendication 5, dans lequel :
- les valeurs Vmin et Vmax sont positionnées de part et d'autre d'une valeur VArc*n/N, VArc correspondant à une tension d'arc prédéfinie pour les matériaux constitutifs des connexions des modules photovoltaïques considérés, la valeur Vmax étant inférieure ou égale à 20V*n/N,
- et les durées Tmin et Tmax sont positionnées de part et d'autre d'une durée Tarc*n/N, avec Tarc correspondant à la durée nécessaire pour appliquer une variation de tension aux bornes de l'ensemble des modules photovoltaïques égale à VARC, Tarc*n/N étant inférieure ou égale à 5*n/N µs.

7. Dispositif de détection d'un arc série dans un dispositif photovoltaïque, fonctionnant en courant continu, comportant N modules photovoltaïques (100, 1, 2, 3), N étant égal à 1 ou strictment supérieur à 1, et un dispositif (10) présentant un comportement capacitif pour les modules, ce dispositif de détection comportant :
a) des moyens (8) pour détecter, aux bornes de n des N modules, n étant supérieur ou égal à 1 ou inférieur ou égal à N, l'évolution temporelle de la tension,
**caractérisé en ce que** ce dispositif comporte en outre :
b) des moyens (8) pour identifier une variation de tension entre :
- une première zone (A) de tension stable ;
- et une deuxième zone (B) de tension, stable pendant une durée d'au moins 5µs, qui suit immédiatement ladite variation de tension,
c) des moyens (8) pour déterminer si la variation de tension est comprise entre une valeur minimum Vmin supérieure ou égale à 0,2 V et une valeur maximum Vmax inférieure ou égale à 20 V, avec un temps de montée de cette variation compris entre une durée minimum Tmin supérieure ou égale à 0,5 µs et une durée maximum Tmax inférieure ou égale à 5 µs.

8. Dispositif selon la revendication 7, lesdits moyens (8) déterminant si la variation de tension est comprise entre Vmin et Vmax, et si le temps de montée est compris entre Tmin et Tmax:
- d'une part par analyse de la pente de la variation de tension en déterminant si cette pente est comprise entre :
* une valeur minimum, donnée par le rapport Vmin/Tmax, égale à 0,04V/µs,
* et une valeur maximum, donnée par le rapport Vmax/Tmin égale à 40 V/µs,
- et, d'autre part, en déterminant si la variation de tension est comprise entre une valeur minimum Vmin supérieure ou égale à 0,2 V et une valeur maximum Vmax inférieure ou égale à 20 V, ou si le temps de montée de cette variation compris entre une durée minimum Tmin supérieure ou égale à 0,5 µs et une durée maximum Tmax inférieure ou égale à 5 µs.

9. Dispositif selon la revendication 7 ou 8, lesdits moyens (8) détectant l'évolution temporelle de la tension aux bornes de l'ensemble des N modules photovoltaïques, la valeur Vmin étant supérieure ou égale à 10V et la valeur Vmax étant inférieure ou égale à 20V.

10. Dispositif selon l'une des revendications 7 à 9, dans lequel :
- les valeurs Vmin et Vmax sont positionnées de part et d'autre d'une valeur de tension d'arc VARC prédéfinie pour les matériaux constitutifs des connexions des modules Photovoltaïques considérés,
- et les durées Tmin et Tmax sont positionnées de part et d'autre d'une durée Tarc correspondant à la durée nécessaire pour appliquer une variation de tension aux bornes de l'ensemble des modules photovoltaïques égale à VARC.

11. Dispositif selon la revendication 7 ou 8, lesdits moyens (8) détectant l'évolution temporelle de la tension aux bornes d'un sous-ensemble de n des N modules photovoltaïques.

12. Dispositif selon la revendication 11, dans lequel :
- les valeurs Vmin et Vmax sont positionnées de part et d'autre d'une valeur VArc*n/N, VArc correspondant à une tension d'arc prédéfinie pour les matériaux constitutifs des connexions des modules photovoltaïques considérés, la valeur Vmax étant inférieure ou égale à 20V*n/N,
- et les durées Tmin et Tmax sont positionnées de part et d'autre d'une durée Tarc*n/N, avec Tarc correspondant à la durée nécessaire pour appliquer une variation de tension aux bornes de l'ensemble des modules photovoltaïques égale à VARC, Tarc*n/N étant inférieure ou égale à 5*n/N µs.

13. Dispositif selon la revendication 7, comportant des moyens pour filtrer des fréquences au moins égales à 100Hz.

14. Dispositif selon l'une des revendications 7 à 13, comportant :
- des moyens (30, 32) formant filtre passif ou formant filtre actif ;
- et/ou des moyens de filtrage analogiques et numériques (50, 52, 54)
- et/ou des moyens (60) pour numériser les tensions mesurées.

15. Dispositif selon l'une des revendications 7 à 14, dans lequel le dispositif (10) présentant un comportement capacitif pour les modules comporte un convertisseur ou un onduleur ou une batterie.

## Patentansprüche

1. Verfahren zum Erfassen eines Serienlichtbogens in einer mit Gleichstrom betriebenen Photovoltaikvorrichtung, enthaltend N Photovoltaikmodule (100, 1, 2, 3), wobei N gleich 1 oder strikt größer als 1 ist, wobei diese Module mit einer Ladevorrichtung (10) verbunden sind, die ein kapazitives Verhalten für die Module zeigt, wobei dieses Verfahren umfasst:
a) Erfassen des zeitlichen Verlaufs der Spannung an den Anschlüssen von n aus N Modulen, wobei n größer oder gleich 1 und kleiner oder gleich N ist,
**dadurch gekennzeichnet, dass** dieses Verfahren ferner umfasst:
b) Erkennen einer Spannungsänderung zwischen:
- einem ersten Bereich (A) mit stabiler Spannung;
- und einem zweiten Bereich (B) mit einer Spannung, die für eine Zeitdauer von zumindest 5 µs stabil ist, die der Spannungsänderung unmittelbar folgt, und
c) Ermitteln, ob die Spannungsänderung zwischen einem Minimalwert Vmin höher oder gleich 0,2 V und einem Maximalwert Vmax niedriger oder gleich 20 V ist, und zwar mit einer Anstiegszeit dieser Änderung zwischen einer minimalen Zeitdauer Tmin größer oder gleich 0,5 µs und einer maximalen Zeitdauer Tmax kleiner oder gleich 5 µs.

2. Verfahren nach Anspruch 1, wobei der Schritt des Ermittelns c) ausgeführt wird durch:
- einerseits Analyse der Steigung der Spannungsänderung unter Ermittlung, ob diese Steigung liegt zwischen:
* einem Minimalwert, der durch das Verhältnis Vmin/Tmax gegeben ist und gleich 0,04 V/µs ist,
* einem Maximalwert, der durch das Verhältnis Vmax/Tmin gegeben ist und gleich 40 V/µs ist,
- und andererseits Ermitteln, ob die Spannungsänderung zwischen einem Minimalwert Vmin höher oder gleich 0,2 V und einem Maximalwert Vmax niedriger oder gleich 20 V liegt, oder ob die Anstiegszeit dieser Änderung zwischen einer minimalen Zeitdauer Tmin größer oder gleich 0,5 µs und einer maximalen Zeitdauer Tmax kleiner oder gleich 5 µs liegt

3. Verfahren nach Anspruch 1 oder 2, wobei der Schritt des Erfassens a) an den Anschlüssen der gesamten N Photovoltaikmodule erfolgt, wobei der Wert Vmin höher oder gleich 10V ist und der Wert Vmax niedriger oder gleich 20 V ist.

4. Verfahren nach Anspruch 1 oder 2 oder 3, wobei
- die Werte Vmin und Vmax beiderseits eines Lichtbogenspannungswerts VARC positioniert sind, der für die Werkstoffe der Verbindungen der betrachteten Photovoltaikmodule vorbestimmt ist,
- und die Zeitdauern Tmin und Tmax beiderseits einer Zeitdauer Tarc positioniert sind, die der Zeitdauer entspricht, die erforderlich ist, um eine Spannungsänderung an den Anschlüssen der gesamten Photovoltaikmodule anzulegen, die gleich VARC ist.

5. Verfahren nach Anspruch 1 oder 2, wobei der Schritt des Erfassens a) an den Anschlüssen einer Untereinheit von n aus N Photovoltaikmodulen erfolgt.

6. Verfahren nach Anspruch 5, wobei
- die Werte Vmin und Vmax beiderseits eines Wertes VArc*n/N positioniert sind, wobei VArc einer vorbestimmten Lichtbogenspannung entspricht, die für die Werkstoffe der Verbindungen der betrachteten Photovoltaikmodule vorbestimmt ist, wobei der Wert Vmax niedriger oder gleich 20V*n/N ist,
- und die Zeitdauern Tmin und Tmax beiderseits einer Zeitdauer Tarc*n/N positioniert sind, wobei Tarc der Zeitdauer entspricht, die erforderlich ist, um eine Spannungsänderung an den Anschlüssen der gesamten Photovoltaikmodule anzulegen, die gleich VARC ist, wobei Tarc*n/N kleiner oder gleich 5*n/N µs ist.

7. Vorrichtung zum Erfassen eines Serienlichtbogens in einer mit Gleichstrom betriebenen Photovoltaikvorrichtung, enthaltend N Photovoltaikmodule (100, 1, 2, 3), wobei N gleich 1 oder strikt größer als 1 ist, und eine Vorrichtung (10), die ein kapazitives Verhalten für die Module zeigt, wobei diese Erfassungsvorrichtung enthält:
a) Mittel (8) zum Erfassen des zeitlichen Verlaufs der Spannung an den Anschlüssen von n aus N Modulen, wobei n größer oder gleich 1 und kleiner oder gleich N ist,
**dadurch gekennzeichnet, dass** diese Vorrichtung ferner enthält:
b) Mittel (8) zum Erkennen einer Spannungsänderung zwischen:
- einem ersten Bereich (A) mit stabiler Spannung;
- und einem zweiten Bereich (B) mit einer Spannung, die für eine Zeitdauer von zumindest 5 µs stabil ist, die der Spannungsänderung unmittelbar folgt, und
c) Mittel (8) zum Ermitteln, ob die Spannungsänderung zwischen einem Minimalwert Vmin höher oder gleich 0,2 V und einem Maximalwert Vmax niedriger oder gleich 20 V ist, und zwar mit einer Anstiegszeit dieser Änderung zwischen einer minimalen Zeitdauer Tmin größer oder gleich 0,5 µs und einer maximalen Zeitdauer Tmax kleiner oder gleich 5 µs.

8. Vorrichtung nach Anspruch 7, wobei die Mittel (8) ermitteln, ob die Spannungsänderung zwischen Vmin und Vmax liegt und ob die Anstiegszeit zwischen Tmin und Tmax liegt durch
- einerseits Analyse der Steigung der Spannungsänderung unter Ermittlung, ob diese Steigung liegt zwischen:
* einem Minimalwert, der durch das Verhältnis Vmin/Tmax gegeben ist und gleich 0,04 V/µs ist,
* einem Maximalwert, der durch das Verhältnis Vmax/Tmin gegeben ist und gleich 40 V/µs ist,
- und andererseits Ermitteln, ob die Spannungsänderung zwischen einem Minimalwert Vmin höher oder gleich 0,2 V und einem Maximalwert Vmax niedriger oder gleich 20 V liegt, oder ob die Anstiegszeit dieser Änderung zwischen einer minimalen Zeitdauer Tmin größer oder gleich 0,5 µs und einer maximalen Zeitdauer Tmax kleiner oder gleich 5 µs liegt.

9. Vorrichtung nach Anspruch 7 oder 8, wobei die Mittel (8) den zeitlichen Verlauf der Spannung an den Anschlüssen der gesamten N Photovoltaikmodule erfassen, wobei der Wert Vmin höher oder gleich 10V ist und der Wert Vmax niedriger oder gleich 20 V ist.

10. Vorrichtung nach einem der Ansprüche 7 bis 9, wobei
- die Werte Vmin und Vmax beiderseits eines Lichtbogenspannungswerts VARC positioniert sind, der für die Werkstoffe der Verbindungen der betrachteten Photovoltaikmodule vorbestimmt ist,
- und die Zeitdauern Tmin und Tmax beiderseits einer Zeitdauer Tarc positioniert sind, die der Zeitdauer entspricht, die erforderlich ist, um eine Spannungsänderung an den Anschlüssen der gesamten Photovoltaikmodule anzulegen, die gleich VARC ist.

11. Vorrichtung nach Anspruch 7 oder 8, wobei die Mittel (8) den zeitlichen Verlauf der Spannung an den Anschlüssen einer Untereinheit von n aus N Photovoltaikmodulen erfassen.

12. Vorrichtung nach Anspruch 11, wobei
- die Werte Vmin und Vmax beiderseits eines Wertes VArc*n/N positioniert sind, wobei VArc einer Lichtbogenspannung entspricht, die für die Werkstoffe der Verbindungen der betrachteten Photovoltaikmodule vorbestimmt ist, wobei der Wert Vmax niedriger oder gleich 20V*n/N ist,
- und die Zeitdauern Tmin und Tmax beiderseits einer Zeitdauer Tarc*n/N positioniert sind, wobei Tarc der Zeitdauer entspricht, die erforderlich ist, um eine Spannungsänderung an den Anschlüssen der gesamten Photovoltaikmodule anzulegen, die gleich VARC ist, wobei Tarc*n/N kleiner oder gleich 5*n/N µs ist.

13. Vorrichtung nach Anspruch 7, enthaltend Mittel zum Filtern von Frequenzen von zumindest gleich 100 Hz enthalten.

14. Vorrichtung nach einem der Ansprüche 7 bis 13, enthaltend:
- Mittel (30, 32), die ein Passivfilter oder ein Aktivfilter bilden;
- und/oder analoge und digitale Filtermittel (50, 52, 54),
- und/oder Mittel (60) zum Digitalisieren der gemessenen Spannungen.

15. Vorrichtung nach einem der Ansprüche 7 bis 14, wobei die Vorrichtung (10), die ein kapazitives Verhalten für die Module zeigt, einen Wandler oder einen Wechselrichter oder eine Batterie enthält.

## Claims

1. Method for detecting a series arc in a photovoltaic device, operating in direct current mode, including N photovoltaic modules (100, 1,2,3), N being equal to 1 or strictly higher than 1, these modules being connected to a charging device (10) having a capacitive behaviour for the modules, this method including:
a) detecting, across n of the N modules, n being higher or equal to 1 or less or equal to N, the time evolution of the voltage,
**characterised in that** the method further comprises:
b) identifying a voltage variation between:
- a first zone (A) of stable voltage;
- and a second zone (B) of stable voltage for a duration of at least 5 µs, which immediately follows said voltage variation, and
c) determining whether the voltage variation is between a minimum value Vmin higher than or equal to 0.2 V and a maximum value Vmax lower than or equal to 20 V, with a rise time of this variation between a minimum duration Tmin higher than or equal to 0.5 µs and a maximum duration Tmax lower than or equal to 5 µs.

2. Method according to claim 1, wherein the step of determining c) is performed:
- on the one hand by analysing the slope of the voltage variation by determining whether this slope is :
* between a minimum value, given by the ration Vmin/Tmax, equal to 0.04 V/µs;
* a maximum value, given by the ration Vmax/Tmin, equal to 40 V/µs,
- and, on the other hand, by determining whether the voltage variation is between a minimum value Vmin higher than or equal to 0.2 V and a maximum value Vmax lower than or equal to 20 V, or whether the rise time of this variation comprised between a minimum duration Tmin higher than or equal to 0.5 µs and a maximum duration Tmax lower than or equal to 5 µs.

3. Method according to claim 1 or 2, wherein the step of detecting a) is performed across the assembly of the N photovoltaic modules, the value Vmin being higher than or equal to 10 V and the value Vmax being lower than or equal to 20 V.

4. Method according to claim 1 or 2, wherein:
- the values Vmin and Vmax are positioned on either side of an arc voltage value VARC predefined for the materials making up the connections of the photovoltaic modules under consideration,
- and the durations Tmin and Tmax are positioned on either side of a duration Tarc corresponding to the duration required for applying a voltage variation across the assembly of the photovoltaic modules which is equal to VARC.

5. Method according to claim 1 or 2, wherein the step of detecting a) is performed across a subassembly n of the N photovoltaic modules.

6. The method according to claim 5, wherein:
- the values Vmin and Vmax are positioned on either side of a value VARC*n/N, VArc corresponding to an arc voltage predefined for the materials making up the connections of the photovoltaic modules under consideration, the value Vmax being lower than or equal to 20V*n/N,
- and the durations Tmin and Tmax are positioned on either side of a duration Tarc*n/N, with Tarc corresponding to the duration required for applying a voltage variation across the assembly of the photovoltaic modules which is equal to VARC, Tarc*n/N being lower than or equal to 5*nN µs.

7. Device for detecting a series arc in a photovoltaic device, operating in direct current mode, including N photovoltaic modules (100, 1,2,3), N being equal to 1 or strictly higher than and a device (10) having a capacitive behaviour for the modules this detecting device including:
a) means (8) for detecting, across n of the N modules, the time evolution of the voltage, n being higher or equal to 1 or less or equal to N, the time evolution of the voltage,
**characterised in that** the device further comprises:
b) means (8) for identifying a voltage variation between:
- a first zone (A) of stable voltage;
- and a second zone (B) of stable voltage for a duration of at least 5 µs, which immediately follows said voltage variation,
c) means (8) for determining whether the voltage variation is between a minimum value Vmin higher than or equal to 0.2 V and a maximum value Vmax lower than or equal to 20 V, with a rise time of this variation between a minimum duration Tmin higher than or equal to 0.5 µs and a maximum duration Tmax lower than or equal to 5 µs.

8. Device according to claim 7, said means (8) determining whether the voltage variation is between Vmin and Vmax, and whether the rise time is between Tmin and Tmax:
- on the one hand by analysing the slope of the voltage variation by determining whether this slope is :
* between a minimum value, given by the ration Vmin/Tmax, equal to 0.04 V/µs;
* a maximum value, given by the ration Vmax/Tmin, equal to 40 V/µs,
- and, on the other hand, by determining whether the voltage variation is between a minimum value Vmin higher than or equal to 0.2 V and a maximum value Vmax lower than or equal to 20 V, or whether the rise time of this variation comprised between a minimum duration Tmin higher than or equal to 0.5 µs and a maximum duration Tmax lower than or equal to 5 µs.

9. Device according to claim 7 or 8, said means (8) detecting the time evolution of the voltage across the assembly of the N photovoltaic modules, the value Vmin being higher than or equal to 10 V and the value Vmax being lower than or equal to 20 V.

10. Device according to one of claims 7 to 9, wherein:
- the values Vmin and Vmax are positioned on either side of an arc voltage value VARC predefined for the materials making up the connections of the photovoltaic modules under consideration,
- and the durations Tmin and Tmax are positioned on either side of a duration Tarc corresponding to the duration required for applying a voltage variation across the assembly of the photovoltaic modules which is equal to VARC.

11. Device according to claim 7 or 8, said means (8) detecting the time evolution of the voltage across a subassembly of n of the N photovoltaic modules.

12. Device according to claim 11, wherein:
- the values Vmin and Vmax are positioned on either side of a value VARC*n/N, VArc corresponding to an arc voltage predefined for the materials making up the connections of the photovoltaic modules under consideration, the value Vmax being lower than or equal to 20V*n/N,
- and the durations Tmin and Tmax are positioned on either side of a duration Tarc*n/N, with Tarc corresponding to the duration required for applying a voltage variation across the assembly of the photovoltaic modules which is equal to VARC, Tarc*n/N being lower than or equal to 5*nN µs.

13. Device according to claim 7, including means for filtering frequencies at least equal to 100 Hz.

14. Device according to any of claims 7 to 13, including:
- means (30, 32) forming a passive filter or forming an active filter;
- and/or analog and digital filtering means (50, 52, 54);
- and/or means (60) for digitizing the measured voltages.

15. Device according to any of claims 7 to 14, wherein the device (10) having a capacitive behaviour for the modules includes a converter or an inverter or a battery.
